# EUROPÄISCHE PATENTSCHRIFT

(11) **EP 4 123 906 B1**
(45) Veröffentlichungstag und Bekanntmachung des Hinweises auf die Patenterteilung: **10.09.2025**
(21) Anmeldenummer: 22182559.9
(22) Anmeldetag: 01.07.2022
(51) Int. Cl.: H03K 17/955

(54) **VERFAHREN UND VORRICHTUNG ZUR ANNÄHERUNGSERFASSUNG**
METHOD AND DEVICE FOR PROXIMITY DETECTION
PROCÉDÉ ET DISPOSITIF DE DÉTECTION D'APPROCHE

(30) Priorität: 21.07.2021 DE 102021118901
(43) Veröffentlichungstag der Anmeldung: 25.01.2023
(73) Patentinhaber: Huf Hülsbeck & Fürst GmbH & Co. KG, 42551 Velbert (DE)
(72) Erfinder: Ziegler, Alexander, 42489 Wülfrath (DE)
(74) Vertreter: Zenz Patentanwälte Partnerschaft mbB

(56) Entgegenhaltungen:
- DE-A1- 102019 133 913
- US-A1- 2013 134 745
- US-A1- 2013 141 121
- US-A1- 2014 111 226

## Beschreibung

Die vorliegende Erfindung betrifft ein Verfahren und eine Vorrichtung zur Annäherungserfassung. Insbesondere betrifft die Erfindung ein Verfahren und eine Vorrichtung zum Einsatz an Fahrzeugen, um durch die Erfassung der Annäherung einer Person oder eines Körperteils der Person an ein Sensorelement der Anordnung eine Aktivierungshandlung für eine Funktion am Fahrzeug zu detektieren

Es ist aus dem Stand der Technik bekannt, dass mittels eines Sensorelements, welches eine Sensorelektrode aufweist, eine veränderliche Kapazität bereitgestellt werden kann, welche Veränderungen in der Umgebung des Sensorelements sensitiv ist. Eine Erfassung der veränderlichen Kapazität ermöglicht es, Änderungen in der Umgebung des Sensorelements zu erfassen. Bei Fahrzeugen kann eine derartige kapazitive Erfassung genutzt werden, um Annäherungen und/oder Gesten zu detektieren, und damit Funktionen am Fahrzeug zu aktivieren.

Die kapazitive Erfassung basiert dabei darauf, dass das Sensorelement mittels einer Ladungsübertragung ausgewertet wird. Die DE 10 2019 133 913 A1 offenbart eine gattungsgemäße Vorrichtung und ein zugehöriges Verfahren. Die dort offenbarte Vorrichtung zur Detektion einer Aktivierungshandlung weist wenigstens ein kapazitives Sensorelement zur Erfassung einer Annäherung auf. Das Sensorelement wird wiederholt mit einer Spannung beaufschlagt und entsprechend seiner Kapazität aufgeladen, anschließend erfolgt eine Umladung der auf dem Sensorelement akkumulierten Ladung auf ein Speicherelement. Eine Gleichrichteranordnung richtet dafür zwischen einer elektrischen Speicheranordnung und dem Sensorelement die Sensorspannung gleich. Anhand der nach einer oder mehreren Umladungen auf der Speicheranordnung gespeicherten Ladungsmenge wird eine Auswertung durchgeführt, wobei anhand der Ladungsmenge geprüft wird, ob diese charakteristisch für eine Annäherung ist.

Bei den bekannten Verfahren und Vorrichtungen besteht ein Problem darin, dass Umgebungsbedingungen eine kapazitive Erfassung und Auswertung erschweren können. Insbesondere Feuchtigkeit, z.B. in Gestalt von Wasserfilmen im Bereich der Sensormittel verschlechtern die Erfassung, ganz besonders wenn diese Wasserfilme elektrischen Massekontakt aufweisen.

Aus dem Dokument DE 10 2019 133 913 A1 ist eine Anordnung mit Sensorelement zur Erfassung einer Annäherungsänderung durch Aktivierungsmittel in einer Umgebung des Sensorelements bekannt. Eine Steueranordnung dient zur Erzeugung eines elektrischen Steuersignals zur Durchführung von wiederholten Ladungstransfers am Sensorelement und für eine kapazitive Sensorauswertung. Eine Übertragungsanordnung dient zur Bereitstellung eines elektrischen Sensorsignals auf der Basis der wiederholten Ladungstransfers und des Steuersignals. Zwischen elektrischer Speicheranordnung und Übertragungsanordnung ist eine Gleichrichteranordnung zur Gleichrichtung des elektrischen Sensorsignals geschaltet. Die Anordnung ist für ein Fahrzeug zur Erfassung eines Aktivierungsvorgangs einer Funktion am Fahrzeug geeignet. Die Anordnung führt eine Erkennung auf Basis der Auswertung zur Ausgabe eines Aktivierungssignals zur Aktivierung der Funktion am Fahrzeug durch, wenn die Ladungsmenge einen Grenzwert überschreitet.

Aufgabe der Erfindung ist es, ein Verfahren und eine Vorrichtung zur Verfügung zu stellen, welche auch bei problematischen Umgebungsbedingungen eine verlässliche Erfassung und Auswertung erlauben.

Diese Aufgabe wird gelöst durch ein Verfahren sowie eine Vorrichtung mit den Merkmalen der unabhängigen Ansprüche.

Der Erfindung liegt die Erkenntnis zugrunde, dass eine Erfassung gegenüber Umweltbedingungen robuster erfolgen kann, wenn diese sowohl die Reaktanz eines Sensorelementes erfasst als auch dessen Resistanz. In den bekannten Vorrichtungen wird ein kapazitiver Sensor mit einem wechselnden Potenzial so aufgeladen und entladen, dass das resultierende Sensorsignal einem Wechselspannungssignal entspricht, in seiner Kurvenform insbesondere einer Schwingung ähnelt. Bei der Erfassung wird das Sensorsignal dann so demoduliert, dass ein Hauptaugenmerk auf der Erfassung der Reaktanz des Sensorelementes liegt, während weitere Komponenten der Impedanz, also die Reaktanz nicht ausgewertet werden. Erfindungsgemäß wird die Erfassung, insbesondere die Demodulation des Sensorsignals so angepasst, dass Reaktanz und Komponenten der Resistanz gemeinsam erfasst werden. Dazu wird erfindungsgemäß über ein Taktsignal die Gleichrichtung des vom Sensormittel erfassten Spannungssignal und die Speicherung der im gleichgerichteten Signal enthaltenen Ladung zeitlich so gesteuert, dass die im Signal enthaltenen additiven Amplituden sowohl der Reaktanz als auch der Resistanz gemessen werden. Das erfindungsgemäß genutzte Verfahren ähnelt dem Konzept der Quadratur-Amplituden-Modulation (Abkürzung QAM) und der zugehörigen Demodulation. Bei der QAM wird ein Träger zweifach, aber mit 90° Phasenverschiebung verwendet, so dass zunächst zwei Träger entstehen. Auf jeden der Träger wird mittels multiplikativer Mischung ein Signal aufmoduliert. Anschließend werden die beiden modulierten Signale addiert, um das Sendesignal zu erhalten. Bei der Demodulation wird mit einer zum Sender identischen Phasenlage eine Trennung der Signale vorgenommen. Erfindungsgemäß wird ausgenutzt, dass die eigentliche Modulation im Sensormittel erfolgt, wo die Impedanz des Sensormittels, (insbesondere kapazitive Reaktanz und die Resistanz) die Modulation bewirkt. Dies gilt, wenn die Sensormittel mit einer Wechselspannung beaufschlagt werden. Die Modulation erfolgt also ohne weiteres aufgrund der resistiven und kapazitiven Anteile der Impedanz im Sensormittel. Bei der Schaltung aus DE 10 2019 133 913 A1, welche auch zur Realisierung der Erfindung geeignet ist, geschieht diese Modulation grundsätzlich ebenfalls.

Die Demodulation erfordert erfindungsgemäß eine besondere Taktung der Gleichrichtung, um das Sensorsignal hinsichtlich Phase und Tastgrad nur in ausgewählten Abschnitten des Sensorsignals der Integration und Speicherung zuzuleiten. Während im Stand der Technik eine Schaltung und Taktung üblicherweise erfolgt, um die kapazitive Reaktanz zu erfassen, werden Phase und Tastgrad erfindungsgemäß geändert, um Resistanz und Reaktanz zu erfassen. Dies geschieht gemäß der Erfindung, indem für den Tastgrad des Taktsignals ein Wert von 0.25 bis 0.6 gewählt wird, bezogen auf die Periodendauer des Sensorsignals. Die Phase wird außerdem so gewählt, dass bezogen auf das Sensorsignal wenigstens zwei Quadranten in die Gleichrichtung und Speicherung einbezogen werden und wenigstens ein Nulldurchgang (oder Wendepunkt) des Sensorsignals einbezogen wird.

Unter Quadranten des Signals ist hierbei jeweils ein Viertel einer vollen Periode zu verstehen, beginnend bei einem Nulldurchgang (oder Wendepunkt) des Sensorsignals (Beginn erster Quadrant), einem ersten positiven Maximum (Ende erster Quadrant und Anfang zweiter Quadrant), einem zweiten Nulldurchgang (Ende zweiter Quadrant und Anfang dritter Quadrant), einem (negativen) Minimum (Ende dritter Quadrant und Anfang vierter Quadrant) und enden mit dem erneuten Nulldurchgang (Ende vierter Quadrant). Eine negative Halbwelle des Sensorsignals erstreckt sich bei dieser Bezeichnung entsprechend über den dritten und vierten Quadranten, die positive Halbwelle hingegen über den ersten und zweiten Quadranten. Die Quadranten enthalten aufgrund der resistiven und kapazitiven Anteile des Signals in unterschiedlichen Abschnitten unterschiedliche Informationen. Im Stand der Technik werden z.B. der dritte und der vierte Quadrant, also die negative Halbwelle gleichgerichtet und integriert, um die Reaktanz zu erfassen. Erfindungsgemäß wird hingegen ein Signalabschnitt mit Nulldurchgang verwendet, um in jedem Fall auch einen Signalanteil der Resistanz einzubeziehen. Das Taktsignal ist synchronisiert mit dem Sensorsignal (welches üblicherweise wiederum mit dem Ansteuerungssignal für den Sensor synchronisiert ist).

Als Gleichrichter kommen insbesondere kohärente Gleichrichter in Frage, da diese nicht nur auf die Amplitude des angebotenen Signals ansprechen, sondern auch seine Phasenlage berücksichtigen. Ein Eingangssignal wird dazu mit einem Referenzsignal verglichen.

Erfindungsgemäß erfolgt periodisch oder in Abhängigkeit von dem Auswertesignal eine Änderung des Tastgrades des Taktsignals aufweist.

Es wird z.B. wiederholt eine Erfassung sowohl von Reaktanz als auch Resistanz vorgenommen, im Wechsel mit Erfassungen mit anderen Anteilen von Reaktanz und Resistanz. So kann eine Grunderfassung der Reaktanz erfolgen, wie im Stand der Technik und durch Gleichrichtung der negativen Halbwelle (dritter und vierter Quadrant des Sensorsignals). In vorgegebenen Abständen werden jedoch der Tastgrad und/oder die Phase des Taktsignals geändert, um gleichzeitig auf einen Anteil der Resistanz zu erfassen. So ist es erfindungsgemäß möglich, bei Änderungen der Umgebung des kapazitiven Sensorelements, z.B. bei einsetzendem Regen, Unterschiede der Signale bei beiden Erfassungsformen zu Erfassen und einen passenden Betrieb zu wählen.

In einer bevorzugten Ausführungsform der Erfindung ist vorgesehen, dass der Tastgrad 0.5 beträgt und die Phase des Taktsignals zu -45° gewählt wird, so dass in die Gleichrichtung des Sensorsignals der dritte Quadrant (also die erste Hälfte der negativen Halbwelle) und jeweils eine Hälfte des zweiten und vierten Quadranten einbezogen werden. Die resultierende Demodulation umfasst dann insgesamt ein Viertel der positiven Halbwelle und drei Viertel der negativen Halbwelle.

Es hat sich gezeigt, dass diese Auswahl eine robuste Auswertung einer Annäherung an die Sensorelektrode erlaubt, auch wenn diese mit einem Flüssigkeitsbelag (auch bei Erdung des Flüssigkeitsbelags) beaufschlagt ist.

Die Erfindung wird nun anhand der beiliegenden Zeichnung näher erläutert.
Fig. 1 zeigt eine Schaltungsanordnung gemäß dem Stand der Technik, welche zur Ausführung des erfindungsgemäßen Verfahrens geeignet ist;
Fig. 2 zeigt eine Detaildarstellung von Komponenten aus Fig. 1;
Fig. 3 zeigt eine schematische Darstellung des Funktionsprinzips der Erfindung;
Fig. 4a zeigt schematisch eine Abstimmung des Taktsignals für den Gleichrichter gemäß dem Stand der Technik;
Fig. 4b zeigt schematisch eine Abstimmung des Taktsignals für den Gleichrichter gemäß einem Ausführungsbeispiel der Erfindung;
Fig. 5 zeigt schematisch den Vergleich von Messsignalen unter gleichen Bedingungen gemäß dem Stand der Technik einerseits und gemäß der Erfindung andererseits;

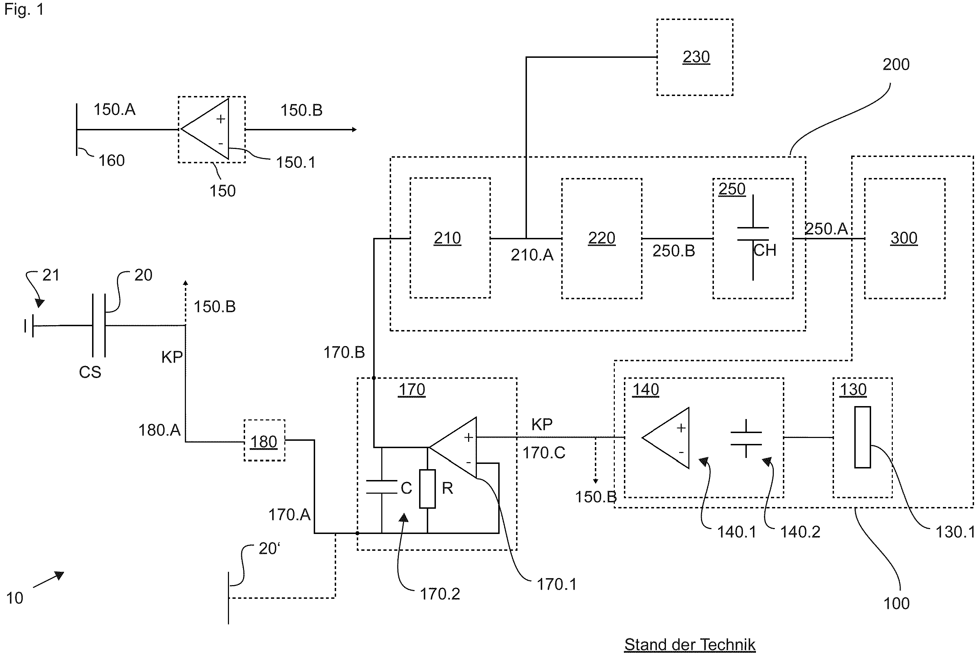

In Fig. 1 ist eine Vorrichtung 10 gemäß dem Stand der Technik gezeigt, welche zur Detektion einer Annäherung gemäß dem erfindungsgemäßen Verfahren geeignet ist. Die Vorrichtung 10 weist wenigstens ein Sensorelement 20 zur Erfassung einer Veränderung in einer Umgebung des Sensorelements 20 auf. Das Sensorelement 20 ist in der Realität durch eine kapazitive Elektrode gebildet, die z.B**.** im Türgriff eines Fahrzeuges oder im hinteren Stossfänger eines Fahrzeuges angeordnet ist (Kick-Sensor). Erfindungsgemäß erfolgt die Auswertung/Demodulation sowohl sensitiv auf Reaktanz als auch der Resistanz des Sensorelements 20, hinsichtlich des gezeigten Aufbaus ist jedoch in den Komponenten des Sensorelements 20 und der übrigen Komponenten in der gezeigten Schaltung kein baulicher Unterschied gegenüber dem Stand der Technik vorhanden, da die Realisierung der Erfindung in einer geänderten Ansteuerung und Demodulation liegt, also einem anderen Betrieb der Komponenten.

Gegenüber der Umgebung und/oder einem Massepotential 21 hat das Sensorelement 20 eine Kapazität (im Folgenden auch als Sensorkapazität CS bezeichnet) und damit auch eine im Wesentlichen durch die Kapazität bedingte Reaktanz. Außerdem hat das Sensorelement 20 eine Resistanz. Durch die Erzeugung eines elektrischen Potentials (mittels einer nachfolgend beschriebenen elektrischen Ansteuerung) an dem Sensorelement 20 wird ein elektrisches Feld in dessen Umgebung erzeugt. Die Sensorkapazität CS wird durch die Veränderung in der Umgebung beeinflusst, ebenso wie dessen Resistanz. Eine Auswertung der Kapazität CS gemäß dem Stand der Technik erfolgt durch Auswertung der im Sensorelement 20 gespeicherten Ladungsmenge und erlaubt Rückschlüsse auf die Veränderung in dessen Umgebung. Die Durchführung von Ladungsübertragungen von und zu dem Sensorelement 20 ist geeignet, anhand der Ladungsübertragungen (wie der übertragenen Ladungsmenge und/oder der dabei erfassbaren Stromstärke und/oder Spannung) ein Sensorsignal bereitzustellen, welches für die Bestimmung der veränderlichen Kapazität CS ausgewertet werden kann.

Um die elektrische Ansteuerung durchzuführen, wird eine Steuer-/Auswerteschaltung 100 verwendet. Die Steuer-/Auswerteschaltung 100 ist zur elektrischen Ansteuerung des Sensorelements 20 über einen Kontrollpfad KP mit dem Sensorelement 20 elektrisch gekoppelt. Durch die elektrische Ansteuerung erfolgt eine (zwangsgeführte) Auf- und Entladung des Sensorelements 20. Die Erfassung wird dadurch bewirkt, dass ein Potenzial durch die Steuer-/Auswerteschaltung 100 am Sensorelement 20 angelegt wird, um das Sensorelement 20 aufzuladen. Es handelt sich dabei um ein wechselndes Potential, sodass eine elektrische Spannung am Sensorelement 20 z. B. als periodische und/oder sinusförmige Spannung erzeugt wird. Zur Auswertung des Sensorelements 20 ist eine Auswerteanordnung 200 vorgesehen, welche eine wiederholte Ermittlung der veränderlichen Kapazität erlaubt.

Es ist optional vorgesehen, dass wenigstens ein Schildelement 160 vorgesehen ist, welches zur Abschirmung des Sensorelements 20 benachbart (und damit im Wirkbereich) zum Sensorelement 20 angeordnet ist. Um eine Abschirmung durch das Schildelement 160 zu ermöglichen, ist eine Schildkontrollanordnung 150 mit einem Anschluss 150.A für das Schildelement 160 vorgesehen. Die Schildkontrollanordnung 150 kann über einen Schildkontrolleingang 150.B zur Bereitstellung der (zuvor beschriebenen) elektrischen Ansteuerung der Steuer-/Auswerteschaltung 100 für das Schildelement 160 elektrisch mit dem Kontrollpfad KP und somit auch mit dem Schildelement 160 verbunden sein. So kann die Schildkontrollanordnung 150 die gleiche elektrische Ansteuerung für das Schildelement 160 bereitstellen, welche auch für das Sensorelement 20 genutzt wird.

Die Steuer-/Auswerteschaltung 100 weist eine Signalgeneratoranordnung 130 auf, welche für die elektrische Ansteuerung des Sensorelements 20 mit dem Sensorelement 20 elektrisch gekoppelt ist, um wiederholt ein elektrisches Ansteuerungssignal zur Aufladung des Sensorelements 20 zu erzeugen. Die Steuer-/Auswerteschaltung 100 weist in dieser Ausführungsform eine Filteranordnung 140 auf z. B. ein Tiefpassfilter. Diese ist der Signalgeneratoranordnung 130 nachgeschaltet, um das Ansteuerungssignal zur elektrischen Ansteuerung des Sensorelements 20 über den Kontrollpfad KP gefiltert an die Sensor-Treiberschaltung 170 auszugeben. Auf diese Weise lässt sich das Ansteuerungssignal mit einer bestimmten Arbeitsfrequenz formen. Damit können vorteilhafterweise EMV (Elektromagnetische Verträglichkeit) Vorgaben bei dem Betrieb der Vorrichtung 10 umgesetzt werden. Die aktive Filterung wird vorzugsweise durch einen Operationsverstärker 140.1 und durch Filterelemente 140.2 wie wenigstens einen Kondensator und/oder wenigstens einen Widerstand und/oder wenigstens eine Spule ermöglicht.

Das durch die Signalgeneratoranordnung 130 erzeugte Ansteuerungssignals liegt gefiltert am Anschluss 170.C an. Die Sensor-Treiberschaltung 170 steuert anhand des Ansteuerungssignals das Sensorelement 20 an. So wird anhand des Ansteuerungssignals eine Ladungsübertragung (Auf- und/oder Entladung) bei dem Sensorelement 20 (ggf. auch an das weitere Sensorelement 20' und/oder das Schildelement 160) initiiert. Der zeitliche Verlauf dieser Ladungsübertragung kann durch die Formung des elektrischen Signals beeinflusst werden. Hierzu weist die Signalgeneratoranordnung 130 z. B. einen Digital-Analog-Konverter 130.1 auf.

Um eine bewirkte Ladungsübertragung an das Sensorelement 20 zu unterbrechen und z. B. wenigstens ein weiteres Sensorelement 20' aufzuladen, kann das Schaltelement 180 getaktet geöffnet und anschließend wieder geschlossen werden. Die Sensor-Treiberschaltung 170 weist einen Verstärker und/oder einen Spannungsfolger und/oder einen Spannungsvervielfacher auf, um ein am Anschluss 170.C anliegendes elektrisches Potential am Sensorelement 20 zu replizieren. Hierzu weist die Sensor-Treiberschaltung 170 einen Operationsverstärker 170.1 und wenigstens ein Verstärkungsmittel 170.2 auf. Ein weiteres Schaltelement 180 kann z. B. im Pfad zwischen dem Anschluss 170.A und dem weiteren Sensorelement 20' gekoppelt sein, und z.B. im Wechsel mit dem Schaltelement 180 geschaltet werden.

Die Sensor-Treiberschaltung 170 bewirkt die wiederholte Ladungsübertragungen zu dem Sensorelement 20 vermittels des Operationsverstärkers 170.1. Für diese Auswertung des Sensorelements 20 hat die Sensor-Treiberschaltung 170 das wenigstens eine Verstärkungsmittel 170.2, welches mit der Auswerteanordnung 200 (und auch mit dem Sensorelement 20) elektrisch gekoppelt ist. Es ist gezeigt, dass das Verstärkungsmittel 170.2 einen Ausgang des Operationsverstärkers 170.1 mit einem (insbesondere invertierenden) ersten Eingang des Operationsverstärkers 170.1 elektrisch koppelt, sodass das Verstärkungsmittel 170.2 eine Gegenkopplung für den Operationsverstärker 170.1 ausbildet. Die Gegenkopplung ermöglicht es, dass die Ladungsübertragungen durch das Ansteuerungssignal gesteuert werden, wenn das Ansteuerungssignal am anderen (insbesondere nicht invertierenden) zweiten Eingang des Operationsverstärkers 170.1 anliegt. Wenn der erste Eingang direkt mit dem Anschluss 170.A elektrisch verbunden ist, wie es auch in Fig. 1 gezeigt ist, wird auf diese Weise durch die Sensor-Treiberschaltung 170 ein Spannungsfolger für das Sensorelement 20 bereitgestellt, sodass die Spannung am (insbesondere niederohmigen) Anschluss 170.A dem Ansteuerungssignal am (insbesondere hochohmigen) Anschluss 170.C folgt. Dies entspricht der Steuerung der Ladungsübertragungen am Anschluss 170.A durch das Ansteuerungssignal, und damit einer (insbesondere niederohmigen) Sensorspeisung. Das Sensorsignal wird am Abgriff 170.B. der Verstärkeranordnung aus dem Operationsverstärker 170.1 und dem Verstärkungsmittel 170.2 bereitgestellt. Das Verstärkungsmittel 170.2 weist wenigstens ein oder zwei Filterelement(e) auf, in diesem Beispiel eine Kapazität C und einen Widerstand R. Durch diese Anordnung werden die Verstärkungsmittel 170.2 gebildet, durch die eine zur Sensorkapazität CS proportionale elektrischen Spannung erzeugt wird. Das Sensorsignal ist dann (insbesondere proportional) abhängig von der Spannung U1 an dem ersten Anschluss 170.A der Sensor-Treiberschaltung 170 (bzw. an dem ersten Eingang des Operationsverstärkers 170.1), verstärkt durch einen Verstärkungsfaktor.

Für die Auswertung der Reaktanz und Resistanz des Sensorelements 20 ist erfindungsgemäß die Ladungsübertragung vom Sensorelement 20 (bzw. des weiteren Sensorelements 20') über die Sensor-Treiberschaltung 170 vorgesehen, hin zu der Auswerteanordnung 200. Es wird wiederholt eine Aufladung und Entladung des Sensorelements 20 über den ersten Anschluss 170.A der Sensor-Treiberschaltung 170 mittels der Ladungsübertragungen durchgeführt. In Abhängigkeit von den Ladungsübertragungen wird ein elektrisches Sensorsignal über den zweiten Anschluss 170.B der Sensor-Treiberschaltung 170 ausgegeben. Abhängig von der Menge der dabei übertragenen Ladung wird eine Speicheranordnung 250, vorzugsweise einen Integrator 250, der Auswerteanordnung 200 aufgeladen. Diese wiederholten Auf- und Entladungen werden durch das Ansteuerungssignal (aufgrund einer sich periodisch verändernden Spannungsamplitude des Ansteuerungssignals) gesteuert.

Die Komponente 300 der Steuer-/Auswerteschaltung 100 ist über einen Anschluss 250.A mit der Speicheranordnung 250 der Auswerteanordnung 200 gekoppelt, um die nach einer oder mehreren Messungen durch die Speicheranordnung 250 akkumulierte elektrische Ladung zur Ermittlung eines für den Zustand des Sensorelements charakteristischen Wertes auszuwerten. Aus diesem Ladezustand wird ein Auswertesignal generiert, welches an eine nachgeordnete Einrichtung, z.B**.** ein zentrales Steuergerät eines Fahrzeugs weitergegeben wird.

Es ist optional, dass vor der Gleichrichtung des Sensorsignals eine elektrische Filterung des Sensorsignals durchgeführt wird. Hierzu kann eine Auswertefilteranordnung 210 genutzt werden, um eine Filterung (wie z. B. eine Bandpassfilterung) des elektrischen Sensorsignals durchzuführen. Dies ermöglicht es störende Immissionen aus der Umgebung des Sensorelements 20 herauszufiltern (EMV-Filterung von Immissionen). Hierzu weist die Auswertefilteranordnung 210 z. B. einen komplexen Widerstand und zusätzlich Filterelemente auf.

Der in Fig. 1 gezeigte Block 220 ist eine Gleichrichteranordnung. Bei der beschriebenen Gleichrichtung kann es sich um eine "kohärente" Gleichrichtung durch den wenigstens einen Gleichrichter handeln. Darunter wird verstanden, dass der wenigstens eine Gleichrichter jeweils gemäß einem vorgegebenen Taktsignal das Sensorsignal von der Auswertefilteranordnung 210 an die Speicheranordnung 250 weiterleitet.

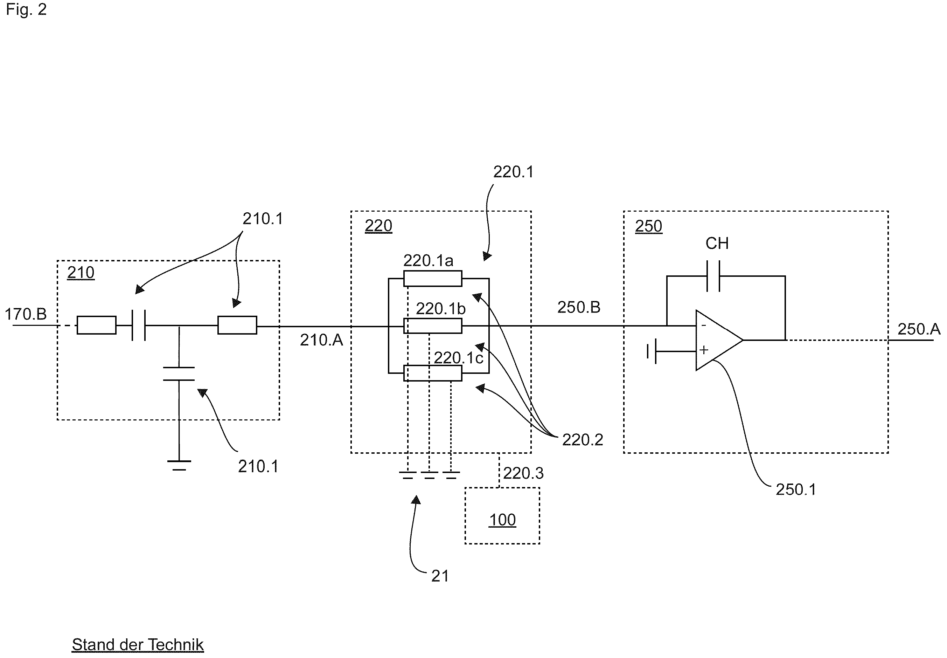

In Fig. 2 sind Details der Auswerteeinrichtung 200 gezeigt, nämlich eine Auswertefilteranordnung 210, eine Gleichrichteranordnung 220 und eine Speicheranordnung 250 mit weiteren Einzelheiten. Die Auswertefilteranordnung 210 dient der Filterung des Sensorsignals, welches durch die Sensor-Treiberschaltung 170 bereitgestellt wird. Dessen Filterelemente können jeweils z. B. als Widerstand, Spule und/oder Kondensator ausgebildet sein, und somit als RC- und/oder RL-Glied (und/oder als RLC-Glied) ausgeführt sein. Durch die Verschaltung und Auslegung der Filterelemente 210.1 kann ein Tief- und Hochpass-Verhalten der Auswertefilteranordnung 210 eingestellt werden, und damit ein Bandpass-Filter bereitgestellt werden. Dieses Bandpass-Filter ist vorteilhafterweise hinsichtlich seines Durchlassbereiches und/oder der Mittenfrequenz an eine Frequenz der elektrischen Ansteuerung, insbesondere eine Arbeitsfrequenz des Ansteuerungssignals, angepasst. Durch die serielle Verschaltung mit einem virtuellen Nullpunkt 250.B der Speicheranordnung 250 kann sodann das gefilterte Sensorsignal als ein Stromsignal an die Speicheranordnung 250 weitergeleitet werden. Auf diese Weise kann eine Ladungsübertragung an und damit Aufladung der Speicheranordnung 250 erfolgen.

Die Gleichrichteranordnung 220 weist wenigstens einen steuerbaren Gleichrichter 220.1 auf, vorzugsweise in der Form eines Synchrongleichrichters oder dergleichen. Der Takt, mit dem die Gleichrichteranordnung angesteuert wird, kann mit der Signalgeneratoranordnung 130 synchronisiert sein.

Während die Vorrichtung in den Figuren 1 und 2 grundsätzlich bekannt ist (z.B. aus der DE 10 2019 133 913 A1), ist die erfindungsgemäße Nutzung und Parametrisierung der Vorrichtung verantwortlich für eine deutlich robustere Erkennung von Annäherungen, auch unter kritischen Umgebungsbedingungen.

Erfindungsgemäß wird das Taktsignal zur Gleichrichtung des Sensorsignals hinsichtlich dessen Phase und Tastgrad so gewählt, dass sowohl Signalanteile der Reaktanz als auch der Resistanz in das gleichgerichtete und in die Speicheranordnung weitergeleitete Signal eingehen.

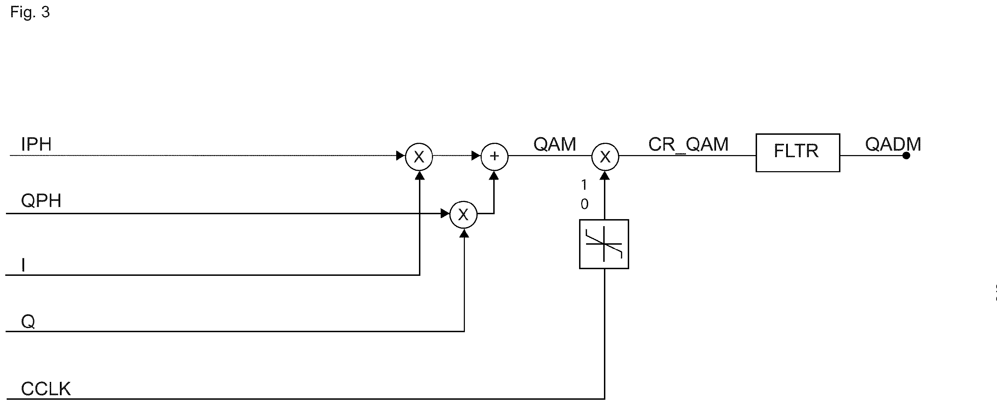

In Fig. 3 ist schematisch das Konzept der erfindungsgemäßen Erfassung gezeigt. Das Prinzip entspricht dem Prinzip der Quadratur-Amplituden-Modulation. Zwei Trägersignale IPH und QPH sind zueinander phasenverschoben (entsprechend einem Sinus- und zugehörigem Cosinus). Auf die jeweiligen Träger werden Signale I und Q aufmoduliert, entsprechend den Anteilen von Resistanz bzw. Reaktanz. Die Signale werden addiert, was in einem modulierten Gesamtsignal QAM resultiert. Ein Taktsignal CCLK stellt einen synchronen phasenverschobenen Gleichrichtertakt bereit, gemäß welchem das Signal QAM zum Signal CR_QAM gleichgerichtet wird. Ein Glättungsfilter FLTR liefert dann das Signal QADM, welches auf maximalen Hub optimiert wird, wenn resistiver und kapazitiver Anteil am Sensorsignal sich gleichzeitig erhöhen.

Aufgrund der in dem Sensorelement vorliegenden kapazitiven und resistiven Anteile kommt es im Sensorelement zu in Fig. 3 durch Träger und Signal-Modulation dargestellten Vorgängen ohne weitere bauliche Veränderungen. Die Taktung und Phase der Auswertung, also die Demodulation ist hingegen ein entscheidender Aspekt, um die im Signal vorhandenen resistiven und kapazitiven Anteile gleichzeitig auszuwerten. Hier sind die Phase der Gleichrichtung und der Tastgrad der Signalauswertung maßgeblich, welche erfindungsgemäß so gewählt werden, dass in das resultierende Signal zur Aufladung einer Speicheranordnung sowohl die Resistanz als auch die Reaktanz eingehen.

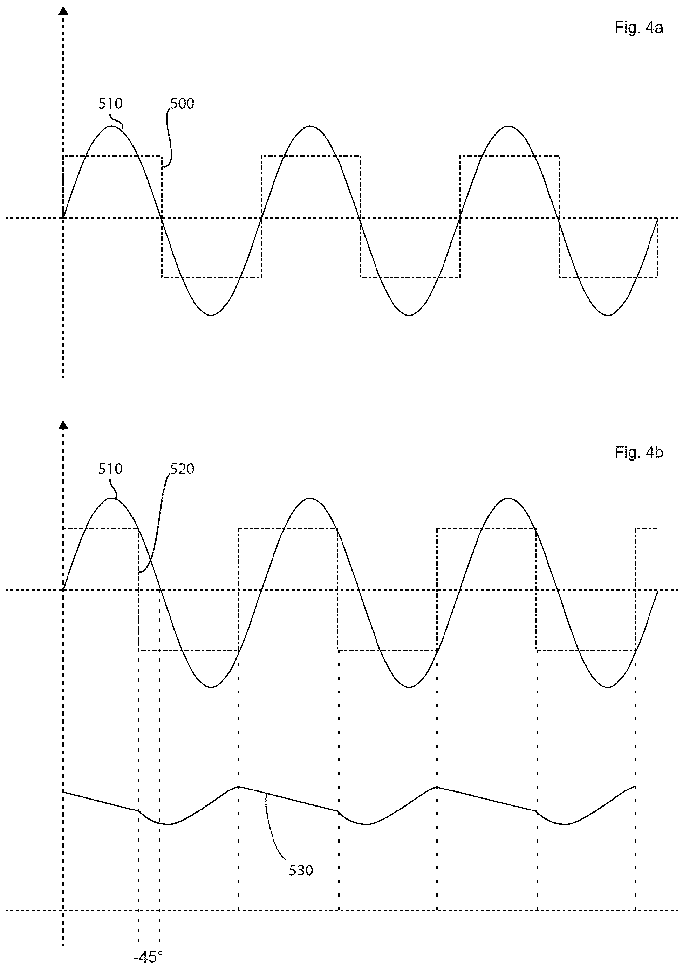

Die Fig. 4a zeig ein Taktschema für eine Auswertung gemäß dem Stand der Technik, wobei durch das Taktsignal 500 ein Signal 510 gleichgerichtet wird. Die Darstellung zeigt die synchrone Abstimmung von Taktung und Sensorsignal 510. In diesem Beispiel wird jeweils die negative Halbwelle des Signals 510, gesteuert durch das Taktsignal 500 einer Gleichrichtung unterzogen und nachfolgend an eine Speichereinrichtung geleitet, welche in Abhängigkeit von dem Signal von dem Sensorelement geladen wird. In dieser Taktung wird die unterschiedliche Aufladung der Speichervorrichtung in erster Linie in Abhängigkeit von der Reaktanz der Sensormittel variiert. Ändert sich also die Kapazität, bedingt dies eine Änderung der in der Speichereinrichtung akkumulierten Ladung.

In Fig. 4b ist demgegenüber eine erfindungsgemäße Taktung mit einem Taktsignal 520 gezeigt, welches eine Phase aufweist, welche auch zu einer Gleichrichtung von Anteilen der positiven Halbwelle des Sensorsignals 510 führt. Es hat sich gezeigt, dass der gezeigte Phasenwinkel von -45° eine deutliche Verbesserung der Robustheit gegenüber verschlechterten Umgebungsbedingungen bietet, insbesondere gegenüber Wasserfilmen mit Massekontakt im Bereich des Sensorelements. Während ein herkömmliches Sensormittel bei Überzug eines Wasserfilms mit Massekontakt vollständig gegenüber Annäherungen blind wird, erlaubt die gezeigte Gleichrichtung und Umladung eine Detektion von Annäherungen auch unter solchen Umständen. Der Kurvenverlauf 530 zeigt schematisch die Integratorspannung am Umkehrintegrator, welcher Teil der Speicheranordnung ist.

Der Tastgrad ist in diesem Beispiel mit 0.5 bezogen auf eine Periode des Sensorsignals gezeigt, eine Variation des Tastgrads ist jedoch im Rahmen der Erfindung möglich, wobei immer ein Nulldurchgang bzw. Wendepunkt durch das Taktsignal und die Gleichrichtung umfasst ist, um Reaktanz und Resistanz gleichzeitig zu erfassen.

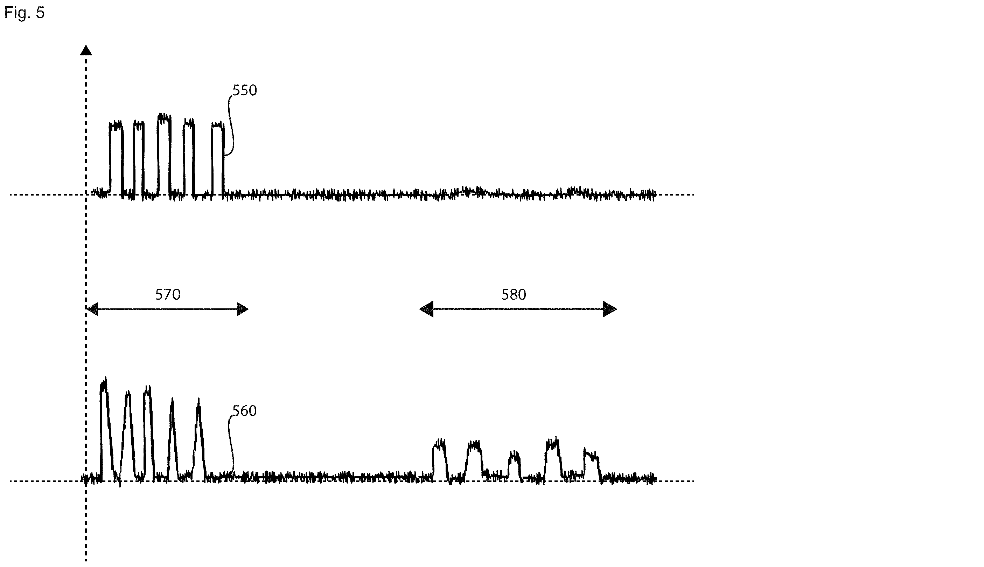

Fig. 5 zeigt Messungen mit ein und derselben baulichen Messanordnung, jedoch bei verschiedener Ansteuerung. Für die Kurve 550 erfolgte eine herkömmliche Taktung der Gleichrichtung und Umladung und in Kurve 560 eine Taktung der Gleichrichtung und Umladung gemäß der Erfindung. Im Zeitabschnitt 570 sind jeweils fünf Annäherungen eines Bedieners an das Sensorelement gezeigt, wobei das Sensorelement mit einem Wasserfilm belegt ist, dieser jedoch ohne Massekontakt ist. Die Messhübe sind vergleichbar, wenn das Tastschema aus Fig. 4a (Kurve 550) und das Tastschema aus Fig. 4b angewandt werden.

Im Zeitabschnitt 580 sind jeweils fünf Annäherungen dargestellt, bei denen der Wasserfilm im Bereich des Sensorelements Massekontakt hat. Hier zeigt sich die robustere Reaktion der erfindungsgemäßen Taktung der Gleichrichtung und Speicherung. Während die Kurve 550 keine auswertbaren Messhübe zeigt, sind die Messhübe in der Kurve 560, also bei Taktung der Gleichrichtung und Umladung nach dem Schema in Fig. 4b, deutlich besser erkennbar und auswertbar. Hier spielt die gleichzeitige Auswertung sowohl der Reaktanz als auch der Resistanz ihre Vorteile aus und das Verfahren weist eine genügend hohe Performance auf, um auch unter diesen Umständen Auswertungen zu ermöglichen.

## Patentansprüche

1. Verfahren zum Betreiben einer Vorrichtung (10) zur Detektion einer Bedienhandlung, wobei die Vorrichtung aufweist:
- wenigstens ein Sensormittel (20, 20'),
- eine mit dem Sensormittel (20, 20') gekoppelte Steuer-/Auswerteschaltung (100), die wenigstens zeitweise ein periodisches elektrisches Ansteuerungssignal zur periodischen Umladung des Sensormittels ausgibt,
- eine mit dem Sensormittel (20, 20') und der Steuer-/Auswerteschaltung (100) gekoppelte Sensor-Treiberschaltung (170), welche ein von dem Sensormittel (20, 20') abgegriffenes Sensorsignal (510) ausgibt,
- eine mit der Sensor-Treiberschaltung (170) gekoppelte steuerbare Gleichrichter-Anordnung (220) zur Gleichrichtung des Sensorsignals (510),
- wobei die steuerbare Gleichrichter-Anordnung (220) mit der Steuer-/Auswerteschaltung (100) gekoppelt ist, um in Abhängigkeit von einem von der Steuer-/Auswerteschaltung (100) ausgegebenen Taktsignal für vorgegebene Phasenabschnitte des Sensorsignals ein gleichgerichtetes Sensorsignal an eine Speicheranordnung (250) zu übertragen,
- wobei mit der Speicheranordnung die Steuer-/Auswerteschaltung (100) zur Ermittlung einer in der Speicheranordnung (250) akkumulierten Ladungsmenge und zur Erzeugung eines von der akkumulierten Ladungsmenge abhängigen Auswertesignals gekoppelt ist,
**dadurch gekennzeichnet, dass**
mit der Steuer-/Auswerteschaltung (100) das Taktsignal (520) zur Ansteuerung des Gleichrichters (220) derart ausgegeben wird, dass es mit dem Sensorsignal (510) synchronisiert ist und einen Tastgrad aufweist, gemäß dem wenigstens 25% und höchstens 75% der Periodendauer des Sensorsignals ein Taktsignal aktiv ist, wobei während des aktiven Taktsignals der Gleichrichter (220) zur Gleichrichtung und Übertragung des gleichgerichteten Sensorsignals an die Speicheranordnung angesteuert wird,
wobei die Phase des Taktsignals (520) so vorgegeben wird, dass von der Gleichrichtung wenigstens ein Nulldurchgang des Sensorsignals (510) umfasst wird,
wobei das Taktsignal periodisch oder in Abhängigkeit von dem Auswertesignal verändert wird und wobei eine Veränderung des Taktsignals eine Änderung des Tastgrades des Taktsignals aufweist.

2. Verfahren nach Anspruch 1, wobei als Gleichrichter (220) ein kohärenter Gleichrichter verwendet wird.

3. Verfahren nach einem der vorangehenden Ansprüche, wobei das Taktsignal (520) derart gewählt wird, dass die Phasenverschiebung des Taktsignals gegenüber dem Sensorsignal (510) -45° Grad beträgt.

4. Verfahren nach Anspruch 1, wobei eine Veränderung des Taktsignals eine Änderung der Phase des Taktsignals aufweist.

5. Verfahren nach einem der vorangehenden Ansprüche, wobei die Speicheranordnung einen Integrator aufweist.

6. Verfahren nach einem der vorangehenden Ansprüche, wobei als Sensormittel eine Elektrodenanordnung verwendet wird, welche entsprechend ihrer Impedanz aufgeladen und entladen wird.

7. Verfahren nach einem der vorangehenden Ansprüche, wobei das Sensorsignal in eine positive und eine negative Halbwelle aufteilbar ist, wobei Tastgrad und Phase des Taktsignals derart vorgegeben werden, dass 25% der positiven Halbwelle und 75% der negativen Halbwelle gleichgerichtet werden.

8. Vorrichtung, aufweisen:
- wenigstens ein Sensormittel (20, 20'),
- eine mit dem Sensormittel gekoppelte Steuer-/Auswerteschaltung (100), die wenigstens zeitweise ein periodisches elektrisches Ansteuerungssignal zur periodischen Umladung des Sensormittels (20, 20') ausgibt,
- eine dem Sensormittel und der Steuer-/Auswerteschaltung (100) gekoppelte Sensor-Treiberschaltung (170), welche ein von dem Sensormittel abgegriffenes Sensorsignal ausgibt,
- eine mit der Sensor-Treiberschaltung (170) gekoppelte steuerbare Gleichrichter-Anordnung (220) zur Gleichrichtung des Sensorsignals und zur Übertragung des gleichgerichteten Sensorsignals an eine Speicheranordnung (250),
- wobei die Gleichrichter-Anordnung mit der Steuer-/Auswerteschaltung (100) gekoppelt ist, um in Abhängigkeit von einem von der Ansteuerschaltung ausgegebenen Taktsignal für vorgegebene Phasenabschnitte des Sensorsignals die Speicheranordnung mit der Sensor-Treiberschaltung zur Übertragung des gleichgerichteten Sensorsignals zu koppeln,
- wobei die Steuer-/Auswerteschaltung (100) mit der Speicheranordnung zur Ermittlung einer in der Speicheranordnung gespeicherten Ladungsmenge und Erzeugung eines von der Ladungsmenge abhängigen Auswertesignals gekoppelt ist,
wobei die Vorrichtung zur Ausführung eines Verfahrens gemäß einem der Ansprüche 1 bis 7 konfiguriert ist.

## Claims

1. Method for operating a device (10) for detecting an operating action, wherein the device comprises:
- at least one sensor means (20, 20'),
- a control/evaluation circuit (100) coupled to the sensor means (20, 20')**,** which at least temporarily outputs a periodic electrical control signal for periodically charging and discharging the sensor means,
- a sensor driver circuit (170) coupled to the sensor means (20, 20') and the control/evaluation circuit (100), which outputs a sensor signal (510) tapped from the sensor means (20, 20'),
- a controllable rectifier arrangement (220) coupled to the sensor driver circuit (170) for rectifying the sensor signal (510),
- wherein the controllable rectifier arrangement (220) is coupled to the control/evaluation circuit (100) in order to transmit a rectified sensor signal to a memory arrangement (250) for predetermined phase sections of the sensor signal in dependence on a clock signal output by the control/evaluation circuit (100),
- wherein the control/evaluation circuit (100) is coupled to the memory arrangement for determining a charge quantity accumulated in the memory arrangement (250) and for generating an evaluation signal dependent on the accumulated charge quantity,
**characterised in that**
the clock signal (520) for driving the rectifier (220) is output by the control/evaluation circuit (100) in such a way that it is synchronised with the sensor signal (510) and comprises a duty cycle according to which at least 25% and at most 75% of the period duration of the sensor signal is active, wherein during the active clock signal the rectifier (220) is controlled for rectifying and transmitting the rectified sensor signal to the memory arrangement,
wherein the phase of the clock signal (520) is predetermined such that the rectification comprises at least one zero crossing of the sensor signal (510),
wherein the clock signal is changed periodically or in dependence on the evaluation signal, and wherein a change in the clock signal comprises a change in the duty cycle of the clock signal.

2. Method according to claim 1, wherein a coherent rectifier is used as the rectifier (220).

3. Method according to one of the preceding claims, wherein the clock signal (520) is selected such that the phase shift of the clock signal relative to the sensor signal (510) is - 45°.

4. Method according to claim 1, wherein a change in the clock signal comprises a change in the phase of the clock signal.

5. Method according to one of the preceding claims, wherein the memory arrangement comprises an integrator.

6. Method according to one of the preceding claims, wherein an electrode arrangement is used as sensor means, which is charged and discharged in accordance with its impedance.

7. Method according to one of the preceding claims, wherein the sensor signal can be divided into a positive and a negative half-wave, wherein the duty cycle and phase of the clock signal are predetermined such that 25% of the positive half-wave and 75% of the negative half-wave are rectified.

8. Device comprising:
- at least one sensor means (20, 20'),
- a control/evaluation circuit (100) coupled to the sensor means, which at least temporarily outputs a periodic electrical control signal for periodically charging and discharging the sensor means (20, 20'),
- a sensor driver circuit (170) coupled to the sensor means and the control/evaluation circuit (100), which outputs a sensor signal tapped from the sensor means,
- a controllable rectifier arrangement (220) coupled to the sensor driver circuit (170) for rectifying the sensor signal and for transmitting the rectified sensor signal to a memory arrangement (250),
- wherein the rectifier arrangement is coupled to the control/evaluation circuit (100) in order to couple the memory arrangement to the sensor driver circuit for transmission of the rectified sensor signal in dependence on a clock signal output by the control circuit for predetermined phase sections of the sensor signal,
- wherein the control/evaluation circuit (100) is coupled to the memory arrangement for determining a charge quantity stored in the memory arrangement and generating an evaluation signal dependent on the charge quantity,
wherein the device is configured to carry out a method according to one of claims 1 to 7.

## Revendications

1. Procédé pour faire fonctionner un dispositif (10) destiné à détecter une opération de commande, le dispositif comprenant :
- au moins un moyen de détection (20, 20'),
- un circuit de commande/d'évaluation (100) couplé au moyen de détection (20, 20'), qui émet au moins temporairement un signal de commande électrique périodique pour charger et décharger périodiquement le moyen de détection,
- un circuit de pilotage de capteur (170) couplé au moyen de détection (20, 20') et au circuit de commande/d'évaluation (100), qui délivre un signal de capteur (510) prélevé par le moyen de détection (20, 20'),
- un dispositif redresseur commandable (220) couplé au circuit de pilotage de capteur (170) pour redresser le signal de capteur (510),
- le dispositif redresseur commandable (220) étant couplé au circuit de commande/d'évaluation (100) afin de transmettre, en fonction d'un signal d'horloge émis par le circuit de commande/d'évaluation (100) pour des phases prédéfinies du signal de capteur, un signal de capteur redressé à un dispositif de mémoire (250),
- le circuit de commande/d'évaluation (100) étant couplé au dispositif de mémoire pour déterminer une quantité de charge accumulée dans le dispositif de mémoire (250) et pour générer un signal d'évaluation dépendant de la quantité de charge accumulée,
**caractérisé en ce que**
le circuit de commande/d'évaluation (100) délivre le signal d'horloge (520) destiné à commander le redresseur (220) de telle sorte qu'il soit synchronisé avec le signal du capteur (510) et présente un rapport cyclique selon lequel au moins 25 % et au plus 75 % de la durée de la période du signal de capteur, un signal d'horloge est actif, le redresseur (220) étant commandé pendant le signal d'horloge actif pour redresser et transmettre le signal de capteur redressé au dispositif de mémoire,
la phase du signal d'horloge (520) étant prédéfinie de telle sorte que le redressement comprend au moins un passage par zéro du signal de capteur (510),
le signal d'horloge étant modifié périodiquement ou en fonction du signal d'évaluation et une modification du signal d'horloge présentant une modification du rapport cyclique du signal d'horloge.

2. Procédé selon la revendication 1, dans lequel un redresseur cohérent est utilisé comme redresseur (220).

3. Procédé selon l'une des revendications précédentes, dans lequel le signal d'horloge (520) est choisi de telle sorte que le déphasage du signal d'horloge par rapport au signal du capteur (510) soit de -45°.

4. Procédé selon la revendication 1, dans lequel une modification du signal d'horloge présente une modification de la phase du signal d'horloge.

5. Procédé selon l'une des revendications précédentes, dans lequel le dispositif de mémoire comprend un intégrateur.

6. Procédé selon l'une des revendications précédentes, dans lequel on utilise comme moyen de détection un dispositif à électrodes qui est chargé et déchargé en fonction de son impédance.

7. Procédé selon l'une des revendications précédentes, dans lequel le signal du capteur peut être divisé en une demi-onde positive et une demi-onde négative, le rapport cyclique et la phase du signal d'horloge étant prédéfinis de telle sorte que 25 % de la demi-onde positive et 75 % de la demi-onde négative soient redressées.

8. Dispositif comprenant :
- au moins un moyen de détection (20, 20'),
- un circuit de commande/d'évaluation (100) couplé au moyen de détection, qui émet au moins temporairement un signal de commande électrique périodique pour la recharge périodique du moyen de détection (20, 20'),
- un circuit de pilotage de capteur (170) couplé au moyen de détection et au circuit de commande/d'évaluation (100), qui délivre un signal de capteur prélevé par le moyen de détection,
- un dispositif redresseur commandable (220) couplé au circuit de pilotage de capteur (170) pour redresser le signal de capteur et pour transmettre le signal de capteur redressé à un dispositif de mémoire (250),
- le dispositif redresseur étant couplé au circuit de commande/d'évaluation (100) afin de coupler, en fonction d'un signal d'horloge émis par le circuit de commande/d'évaluation pour des phases prédéfinies du signal de capteur, le dispositif de mémoire au circuit de pilotage de capteur pour la transmission du signal de capteur redressé,
- le circuit de commande/d'évaluation (100) étant couplé au dispositif de mémoire pour déterminer une quantité de charge stockée dans le dispositif de mémoire et générer un signal d'évaluation dépendant de la quantité de charge,
le dispositif étant configuré pour exécuter un procédé selon l'une des revendications 1 à 7.
